# EUROPEAN PATENT APPLICATION

(11) **EP 4 683 227 A1**
(43) Date of publication of application: **21.01.2026**
(21) Application number: 24210126.9
(22) Date of filing: 31.10.2024
(51) Int. Cl.: H03K 19/0185

(54) **A LEVEL SHIFTER CIRCUIT**

(30) Priority: 16.07.2024 IN 202441054390
(71) Applicant: Samsung Electronics Co., Ltd., Suwon-si, Gyeonggi-do 16677 (KR)
(72) Inventor: CHOWHAN, M Trinath, 560048 Bengaluru (IN); SUDHAKAR, Jaggarapu, 560048 Bengaluru (IN); AKHILA, Tammineedi, 560048 Bengaluru (IN)
(74) Representative: Marks & Clerk LLP

(57) **Abstract**

A single stage level shifter includes a first MOS device which bypasses a high resistance path generated by a p-type transistor at a left branch of a voltage level shifter block. A second MOS device reduces resistance created by the n-type transistor at the left branch of the level shifter block, so that the single stage level shifter is able to perform over a wide range of high core (input) voltages. A p-type transistor block pulls down an n-side of an N-side final output 326 of a level shifter block at a right branch of the single stage level shifter. Also, an n-type transistor block assists in changing a final output block of the single stage level shifter 324 to a level high.

## Description

### TECHNICAL FIELD

Embodiments disclosed herein relates to semiconductor integrated circuits, and more particularly, to a voltage level shifter circuit.

### BACKGROUND

In the related art, a single stage level shifter circuit needs additional bias to meet a reliability requirement of a voltage level shifter circuit. The reliability of a semiconductor device is the probability that it will perform its function under specified conditions for a set time. However, addition of additional bias may in turn limit the operating voltages, drawing more current and increasing area of the circuit.

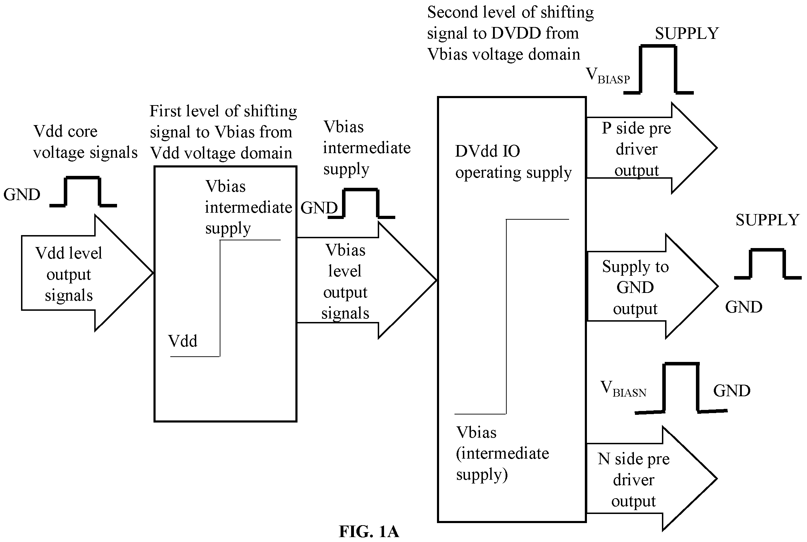

Comparative solutions to mitigate reliability concerns, which do not implement embodiments of the present disclosure, comprise using a use two stage level shifter. FIG. 1A shows a block diagram of a two-stage level shifter, according to such a comparative example. A two-stage level shifter has a limit on an operating voltage range due to lesser overdrive. In order to improve the overdrive strength, the sizes of the device components are increased. Hence, the area of the circuit increases, and the circuit thereby draws more current. There may be higher delays and more leakage currents in the circuit. Hence, considering area and power as the major constraint as the area of the circuit increases, and the circuit thereby draws more current, comparative architectures have a limited range of supported voltages.

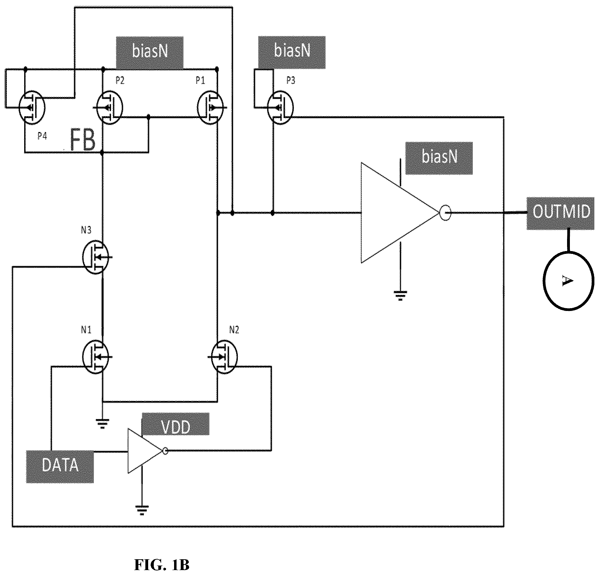

FIG. 1B shows an example circuit diagram of a first stage voltage level shifter of a voltage level shifter according to a comparative example. The first stage of the two-stage voltage level shifter uses Wilson current mirror logic (P1, P2, and P4) to shift the core voltage to an intermediate bias voltage. A feedback net (FB1) here is of intermediate supply level, hence there won't be any reliability issues. The input to the first stage is received through an NMOS (N1) and an inverted input through an inverter to a gate terminal of an NMOS (N2). The NMOS N1 is connected to an NMOS N3, and NMOS N3 is then connected in series to a Wilson current mirror circuit. The NMOS N2 is also connected to the Wilson current mirror and an intermediate output inverter to produce an intermediate output. A feedback is taken from the intermediate output and given to a gate terminal of a PMOS P3 and the gate terminal of N3. The gate terminal of the NMOS N3 is triggered by the intermediate output.

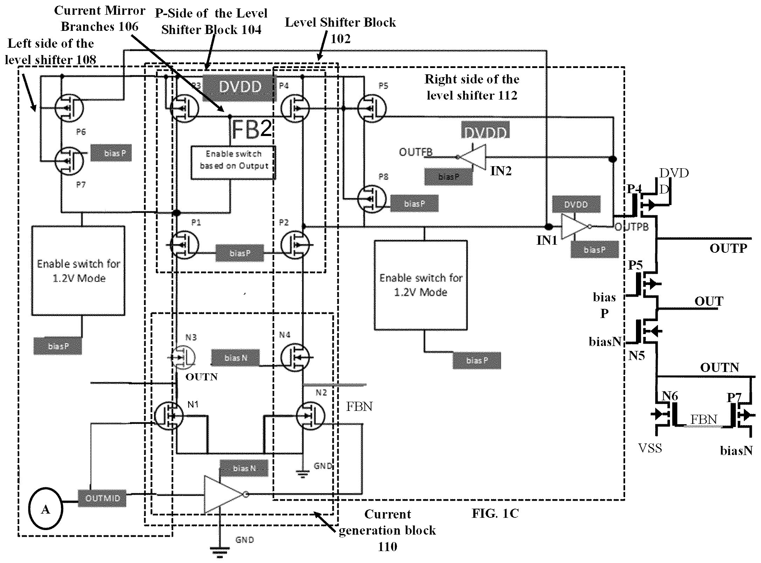

FIG. 1C shows an example circuit diagram of a second stage voltage level shifter of a voltage level shifter according to a comparative example. The comparative example voltage level shifter may include a level shifter block 102. The level shifter block includes a current generation block 110 and a P side of the level shifter block 104. The current generation block 110 may include NMOSes N1, N2, N3, and N4. The P side of the level shifter block 104 includes current mirror branches 106 including PMOSes P1, P2, P3, and P4.

A PMOS P6 is connected in series with a PMOS P7, and a source terminal of P6 and a source terminal of P7 is connected to a drain terminal of P3 of the current mirror branch 106. The drain terminal of P3 is connected to a power source DVDD. A drain terminal of P7 is connected in junction with a source terminal of P1 and a source terminal of P3, and the drain terminal of P7 also connects to a enable switch which in turn connects to the source terminal of P3 and source terminal of P4, making a second feedback path (FB2). The drain terminal of P7 is also connected to an enable switch for 1.2 V mode. The enable switch receives a P type bias voltage (BiasP). A gate terminal of P10 is connected with a gate terminal of N1 of the current generation block 110. The gate terminal of P10 is also connected to the intermediate output of the first stage voltage level shifter in FIG. 1B, that is given as the input to the current generation block through an inverter. The source terminal of P10 is connected to a N type bias voltage (BiasN). The PMOS P6, P7 and P10 and their connection with the level shifter block 102 makes the left side of the level shifter block 108.

At the right side of the voltage level shifter block 112, a PMOS P5 is connected in series with a PMOS P8, and a drain terminal of P5 and a drain terminal of P8 is connected to a drain terminal of P4 of the current mirror branch 106. The drain terminal of P4 is connected to a power source DVDD. A source terminal of P8 is connected injunction with a drain terminal of P2 and a source terminal of P4, and the source terminal of P8 also connects to a enable switch for 1.2V mode. The enable switch receives a P type bias voltage (BiasP). The gate terminal of P8 receives BiasP as the gate input.

The source terminal of P8 connected injunction with the drain terminal of P2 and the source terminal of P4, is further connected to an output inverter IN1. A gate terminal of the PMOS P6 is connected to the output inverter IN1. The inverter IN1 generates the output OUTPB. The OUTPB is given as the signal at a gate terminal of the PMOS P5. Also, OUTPB is again connected to another inverter IN2 to generate OUTFB.

In the comparative example in FIG. 1B and 1C, the voltage limits can be improved by increasing size of the transistor switches on a left side of a voltage level shifter 108, or increasing the stacking of current mirror branches at a P side of the voltage level shifter 104. However, these changes impact the current generation block 110 of the voltage level shifter 102, demanding additional current when core voltages are low. The requirement of additional current at low core voltages may require an increase in size of transistors in the current generation block of the voltage level shifter. The techniques thus increase the area of the circuit and also increase the current requirement in the circuit.

On the right side of the voltage level shifter block 112, the feedback voltage FBN needs to be controlled especially at low IO voltage supplies and higher frequencies. The shorting with the N-side final output (OUTN) is limited with frequency and low IO voltages, as when the frequency increases and supplies goes low. Specifically, in the case of 0.85 V in 1.2V mode, there will not be enough drive strength for PMOS P4 to charge the FBN net to the supply voltage, with smaller sizes of transistors as they are more resistive due to lesser drive strength.

Therefore, the single stage voltage level shifter has more reliability issues. In order to meet the requirement of lesser area and power, the voltage range and frequency support is compromised.

OBJECTS One or more embodiments provide a single stage voltage level shifter.

Further, one or more embodiments provide a high voltage tolerant and a wide range, single stage voltage level shifter.

Another object of embodiments herein is to disclose bypassing of a high resistance path generated by the p-type transistor at the left branch of the voltage level shifter block.

Another object of embodiments herein is to disclose generating a first low resistance path, in between a current generating block and a current mirroring block.

Another object of embodiments herein is to disclose generating a second low resistance path at a left branch of the voltage level shifter circuit.

Another object of embodiments herein is to disclose reduction of a resistance created by the n-type transistor at the left branch of the voltage level shifter block that covers wide range of high core voltages.

Another object of embodiments herein is to disclose driving a current mirror block up to a maximum capacity.

Another object of embodiments herein is to disclose pull up an n-side of the N-side final output of the voltage level shifter block.

Another object of embodiments herein is to disclose boosting a n-type feedback signal to reach a maximum logic level in the voltage level shifter circuit in a time period.

Another object of embodiments herein is to disclose pulling down, a p-side of the N-side final output of the voltage level shifter block at a right branch.

Another object of embodiments herein is to disclose shifting of a wide range of core voltage levels to the wide range of I/O voltage levels.

### SUMMARY

According to an aspect of an example embodiment, a level shifter circuit includes: a p-type transistor; a first metal-oxide semiconductor (MOS) device connected to the p-type transistor; a voltage level shifter block comprising: a current mirror block, wherein the first MOS device is connected to the current mirror block at a left branch of the voltage level shifter block, a current generation block, a transistor block, and a second MOS device connected to the transistor block and to the current generation block of the left branch, wherein a gate terminal of the second MOS device is connected to a final output of the level shifter circuit, and a source terminal of the first MOS device is connected to a drain terminal of the second MOS device; a p-type transistor block connected to an N-side final output of the voltage level shifter block, wherein the p-type transistor block is configured to receive input from the left branch; and an n-type transistor block connected at a right branch of the level shifter circuit, wherein the n-type transistor block is configured to receive input from the N-side final output of the level shifter circuit.

According to an aspect of an example embodiment, a method to shift a level of a voltage in a level shifter circuit, includes: generating a first low resistance path, by a first metal oxide semiconductor (MOS) device, through a first MOS device from a p-type transistor connected to a current generation block and to a current mirror block, thereby strengthening the current mirror block of a voltage level shifter block; generating a second low resistance path via a connection of a final output of the level shifter circuit to a gate terminal of a second MOS device to drive the current mirror block up to a maximum capacity; receiving a first feedback, provided by the second low resistance path connected to a p-type transistor block, wherein the first feedback is configured to boost an n-type feedback voltage to reach a maximum logic level; receiving a second feedback from an n-type transistor block; and generating, the final output at high frequencies and over a wide range of voltages based on the first feedback and the second feedback.

These and other aspects of the embodiments herein will be better appreciated and understood when considered in conjunction with the following description and the accompanying drawings. It should be understood, however, that the following descriptions, while indicating at least one embodiment and numerous specific details thereof, are given by way of illustration and not of limitation. Many changes and modifications may be made within the scope of the embodiments herein, and the embodiments herein include all such modifications. At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1A shows a block diagram of a two stage voltage level shifter, according to a comparative example;
FIG. 1B shows an example circuit diagram of first stage voltage level shifter of a voltage level shifter, according to a comparative example;
FIG. 1C shows an example circuit diagram of second stage voltage level shifter of a voltage level shifter, according to a comparative example;
FIG. 2 shows a block diagram for a single stage voltage level shifter, according to one or more embodiments;
FIG. 3 shows a block diagram of a single stage voltage level shifter, according to one or more embodiments;
FIG. 4 shows an example of the voltage level shifter circuit, according to one or more embodiments;
FIG. 5 shows a flowchart for a method to shift the level of voltage in a voltage level shifter circuit according to one or more embodiments;
FIG. 6A shows a graphical representation of an example for level shifting from core level voltage to IO level voltage, according to one or more embodiments; and
FIG. 6B shows a graphical representation of an example for level shifting from core level voltage to low IO level voltage, according to one or more embodiments

### DETAILED DESCRIPTION

Example embodiments and the various features and advantageous details thereof will be explained more fully with reference to the accompanying drawings. Descriptions of well-known components and processing techniques may be omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

For the purposes of interpreting this specification, the definitions (as defined herein) will apply and whenever appropriate the terms used in singular will also include the plural and vice versa. It is to be understood that the terminology used herein is for the purposes of describing particular embodiments only and is not intended to be limiting. The terms "comprising", "including", "having" and "including" are to be construed as open-ended terms unless otherwise noted.

The words/phrases "exemplary", "example", "illustration", "in an instance", "and the like", "and so on", "etc.", "etcetera", "e.g.,", "i.e.," are merely used herein to mean "serving as an example, instance, or illustration." Any embodiment or implementation of the present subject matter described herein using the words/phrases "exemplary", "example", "illustration", "in an instance", "and the like", "and so on", "etc.", "etcetera", "e.g.,", "i.e.," is not necessarily to be construed as preferred or advantageous over other embodiments.

Embodiments herein may be described and illustrated in terms of blocks which carry out a described function or functions. These blocks, which may be referred to herein as managers, units, modules, hardware components or the like, are physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure.

It should be noted that elements in the drawings are illustrated for the purposes of this description and ease of understanding and may not have necessarily been drawn to scale. For example, the flowcharts/sequence diagrams illustrate the method in terms of the operations required for understanding of aspects of the embodiments as disclosed herein. Furthermore, in terms of the construction of the device, one or more components of the device may have been represented in the drawings by conventional symbols, and the drawings may show only those specific details that are pertinent to understanding the present embodiments so as not to obscure the drawings with details that will be readily apparent to those of ordinary skill in the art having the benefit of the description herein. Furthermore, in terms of the system, one or more components/modules which comprise the system may have been represented in the drawings by conventional symbols, and the drawings may show only those specific details that are pertinent to understanding the present embodiments so as not to obscure the drawings with details that will be readily apparent to those of ordinary skill in the art having the benefit of the description herein.

The accompanying drawings are used to help easily understand various technical features and it should be understood that the embodiments presented herein are not limited by the accompanying drawings. As such, the present disclosure should be construed to extend to any modifications, equivalents, and substitutes in addition to those which are particularly set out in the accompanying drawings and the corresponding description. Usage of words such as first, second, third etc., to describe components/elements/steps/operations is for the purposes of this description and should not be construed as sequential ordering/placement/occurrence unless specified otherwise.

One or more embodiments herein achieve a single stage voltage level shifting by a single stage voltage level shifter.

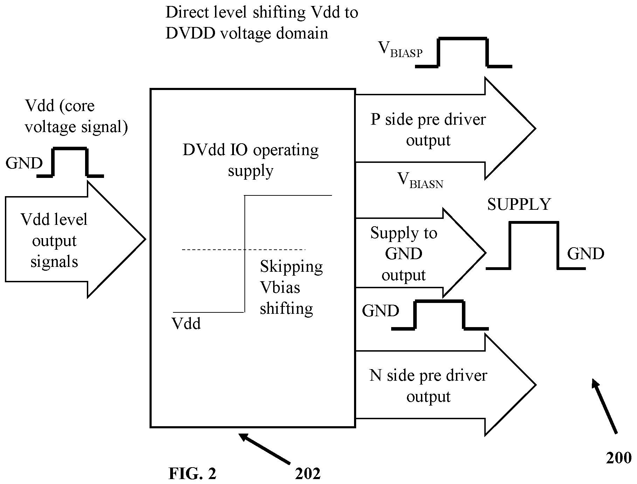

FIG. 2 shows a block diagram for a single stage voltage level shifter 200 according to one or more embodiments. The voltage level shifter takes a voltage as an input in core domain. For example, VDD domain. The voltage level shifter 200 includes a level shifting block (202) that shifts the voltage to a desired voltage level in IO domain, for example DVDD domain. The desired voltage level is an input-output (I/O) operating voltage. In one or more embodiments, the voltage level shifter 200 is a single stage voltage level shifter. The present voltage level shifter 200 skips the bias voltage shifting, by directly shifting the input voltage to the I/O operating voltage. In one or more embodiments, voltage level shifter 200 may have three outputs, that is a first output including a supply to ground output matching the input-output voltage level (termed as the final output (OUT) in FIG. 2), a second output including a n-type bias to ground output (termed as N-side final output 326 and referred to as OUTN in FIG. 2), and a third output including a supply to p-type bias output (referred to as OUTP in FIG. 2).

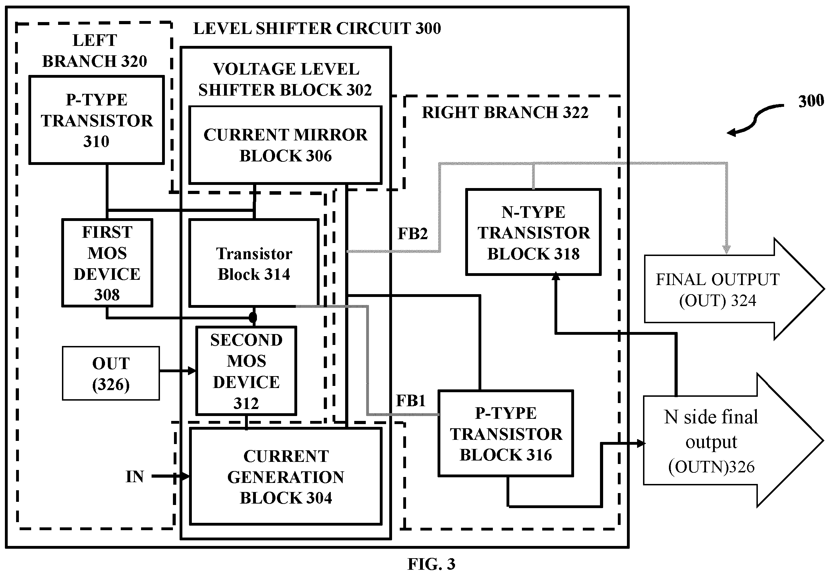

FIG. 3 shows a block diagram of a single stage voltage level shifter circuit 300, according to one or more embodiments. A voltage level shifter circuit 300 includes a voltage level shifter block 302. The voltage level shifter block 302 further includes a current generation block 304 and a current mirror block 306.

In one or more embodiments, the current generation block 304 may have N-type transistors cascaded if required. In one or more embodiments, the current mirror block 306 includes P-type transistors cascaded if required.

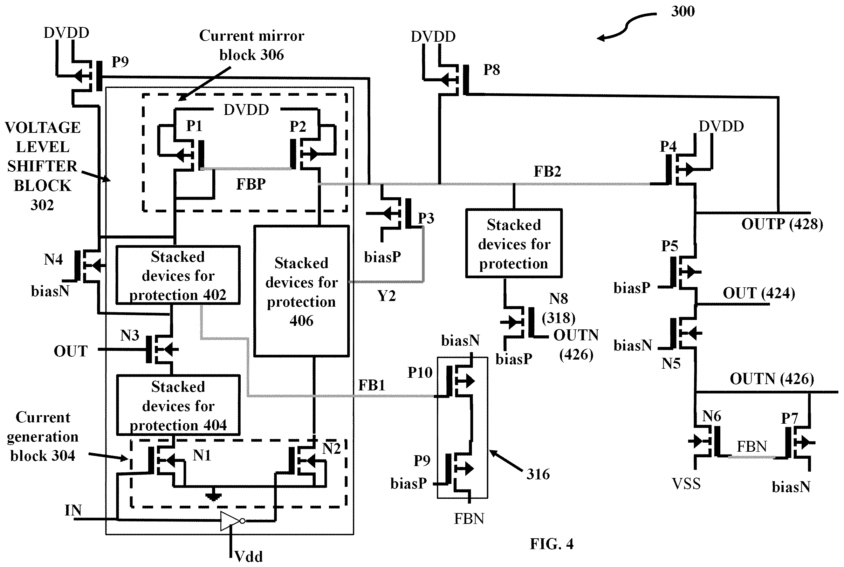

The voltage level shifter circuit 300 includes a first metal oxide semiconductor (MOS) device 308 connected between a current generation block 304 and a current mirror block 306 at a left branch of a voltage level shifter block 302. In one or more embodiments, the first MOS device 308 is an NMOS device. The first MOS device 308 generates a first low resistance path in the left branch 320 of the voltage level shifter circuit 300. The first MOS device 308 bypasses a high resistance path generated by the transistor block 314 at the left branch 320 of the voltage level shifter block 302. The transistor block 314 may include, but is not limited to a p-type or n-type type transistors stacked together. The p-type transistors or the n-type transistors are stacked together for protection. The first MOS device 308 strengthens the current mirror block 306 for covering a wide range of IO voltages, especially when the p-type of transistor is weaker due to receiving low values of supply voltage. For example, the proposed circuit supports IO voltages ranging from 0.80V to 2.2V. In one or more embodiments, the first MOS device 308 enables the voltage level shifter circuit 300 to operate at a wide range of input-output (I/O) voltages; i.e., the circuit may cover a wide range I/O voltage. The voltage level shifter circuit 300 is reliable at a wide range of input output voltages, core voltages and at high frequencies. In some embodiments, a gate of a P-type transistor (P9 in FIG. 4, 310 in FIG. 3) is connected to an output of the current mirror block 306, a source of P9 is connected to the first MOS device 308 (corresponding to N4 in FIG. 4). A drain of P9 is connected to DVDD (see FIG. 4).

In one or more embodiments, a second MOS device 312 is connected to a transistor block 314 at the left branch 320 of the voltage level shifter block 300. In one or more embodiments, the second MOS device 312 is a NMOS device. A final output 324 of the voltage level shifter circuit 300 is given as a gate signal at a gate terminal of the second MOS device 312 at the left branch 320 of the voltage level shifter block 302. The second MOS device 312 reduces overall resistance between block 304 and 306 at the left branch 320 of the voltage level shifter block 302, therefore the voltage level shifter 300 may cover a wide range of high core voltages. The second MOS device 312 is connected to the first MOS device 308. In one or more embodiments, the connection of the gate terminal of the second MOS device 312 makes a second low resistive path from the second MOS device 312 to the transistor block 314. The second MOS device 312 reduces the resistance created by the transistor block 314 at the left branch 320 of the voltage level shifter block 302 that covers wide range of high core voltages. Therefore, the current mirror block 306 and the current generation block 304 is driven up to a maximum capacity by reducing the resistances of the transistor block 314. The input voltage, IN (a core voltage), is input to the current generation block 304. The second MOS device 312 adds strength to the current generation block 304 as the final output (OUT) is connected the gate terminal of the second MOS device, that covers a wide range of core voltages, especially when core voltages are too low.

In one or more embodiments, the p-type transistor block 316 receives input from the transistor block 314 the left branch 320 of the voltage level shifter block 302 thereby creating a first feedback path. The N-side final output 326 of the voltage level shifter block 302 is derived from the p-type of transistor block 316. The p-type transistor block 316 pulls up a feedback net (FBN)) to a n-type bias voltage level with the help of first feedback at the right branch 322 of the voltage level shifter block 302. Pulling up the FBN gives maximum overdrive to an NMOS device N6, so the n-type of N-side final output (OUTN) is pulled to logic low.

In one or more embodiments, a first feedback path is generated FB1. The first feedback path FB1 is connected from the drain terminal of a transistor in the transistor block 314 of the left branch of the voltage level shifter block 302 to the p-type transistor block 316. The first feedback path FB1 detects a first feedback from the drain terminal of a transistor in the stacked transistor block314, which is connected to a p-type transistor block 316. The first feedback is detected earlier than a second feedback path (FB2) by the connection of the first feedback path FB1 to a transistor of the transistor block 314, that stabilizes an N type of transistor in the N-side final output 326 which improves the frequency of voltage level shifter circuit 300 at low voltage supplies. For example, the voltage level shifter supports frequency up to 300MHz. The p type of transistor block 316 reduces the dependency of the second feedback path FB2 on the N-side final output 326 by detecting the FB1 early, ultimately helping in achieving improved frequencies at lower supplies where the second feedback path FB2 charges at a slow rate, due to lesser strengths of current mirror block 306.

In one or more embodiments, an n-type transistor block 318 is connected to an output side of the current mirror block 306. The n-type of transistor block 318 takes input from the N-side final output 326 of the voltage level shifter circuit. At high frequencies and low voltages, the second feedback path FB2 needs to pull the final output OUT 324 to Supply (logic high) level. As the discharging time of the second feedback path is more, the n-type transistor block 318 is connected to the second feedback path (FB2) using the N side final output (OUTN), that helps in achieving faster discharge time and allows the second feedback path to pull up the final output (OUT) to the supply voltage. The n-type transistor block 318 detects logic high of the final output OUT sooner. A signal from the right-side output block 326 is connected to a gate terminal of the n-type transistor block 318. The connection of the OUTN to the gate terminal of the n-type transistor block 318 detects the logic high of the final output sooner by boosting a logic low of the second feedback path FB2 soon. The early detection of the second feedback enables the voltage level shifter circuit 300 to operate at low supplies and higher frequencies. The generated output is stable at high frequencies and low supply voltages.

In one or more embodiments, the voltage level shifter circuit 300 is a high voltage tolerant and a wide range, single stage voltage level shifter. The final output includes a supply to ground level output, and the N-side final output 326 includes n-type bias to ground level output. The voltage level shifter circuit 300 also has a third output that includes one of a supply to p-type bias output. For example, the core voltages range from 0.3V to 1.5V, IO voltages from 0.80V to 2.2 V and the voltage level shifter supports frequency up to 300MHz.

FIG. 4 shows an example block diagram of a single stage voltage level shifter, according to one or more embodiments. In FIG. 4, a p-type MOS device P4 has a gate connected to the second feedback path FB2, a drain connected to DVDD and a source connected both to a p-type MOS device P8, and provides an output OUTP (428). Output OUTP is connected to a drain of a p-type MOS device P5, which has a gate connected to bias P and a source connected to the drain of an n-type MOS device N5. The output level-shifted voltage OUT (424) is obtained at the connection of the source of the p-type MOS device P5 to the drain of the N-type MOS device N5. The source of the N-type MOS device N5 provides the signal OUTN 426. The source of N-type MOS device N5 is connected to the drain of the NMOS device N6 and the drain of a PMOS device P7. A voltage level shifter circuit 300 includes a voltage level shifter block 302 including a current generation block 304 and a current mirror block 306. In one or more embodiments, N type transistors are connected in the current generation block 304. In one or more embodiments, P type transistors are connected in the current mirror block 306. In one or more embodiments, the N type transistors may be cascaded in the current mirror block 306 and the P type transistors may be cascaded in the current generation block 304.In one or more embodiments, transistors may be field effect transistors, such as, but not limited to, at least one of a junction field effect transistor (JFET), a metal-semiconductor FET (MESFET), an insulated gate FET, and a metal oxide semiconductor FET (MOSFET), (FINFET) and Gate all around (GAA). In one or more embodiments, the current generation block 304 includes NMOS devices, N1 and N2. In one or more embodiments, the current mirror block 306 includes PMOS devices, P1 and P2.

In one or more embodiments, the voltage level shifter circuit includes a first metal oxide semiconductor (MOS) device N4 connected to a PMOS device P1 at a left branch of a voltage level shifter block 302. In one or more embodiments, the MOS device is an NMOS device. The first MOS device N4 is configured to bypass a high resistance path generated by stacked devices for protection 402 at the left branch of the voltage level shifter block 302. The first MOS device N4 enables the voltage level shifter circuit 300 to operate at a wide range of input-output (I/O) voltages, i.e., the circuit may cover wide range I/O voltages.

As shown in FIG. 4, the p-type feedback node (FBP) voltage is limited by the p-type transistor (P9) and the stacked devices for protection 402 at a left branch of a voltage level shifter block 302. The stacked devices for protection (402) becomes more resistive when supply voltage is a logic low. In an example herein, the supply voltage may be as low as 1.4V as the gate threshold voltage (VGS) is low.

In one or more embodiments, the first MOS device N4 is connected to the p-type of the transistor (P9) and the p-type transistor P1 of the current mirror block on the left branch of the voltage level shifter block 302. In one or more embodiments the first MOS device N4 is a NMOS device. The first MOS device N4 generates a low resistance path to bypass a high resistance path, wherein the high resistance path is generated by the stacked devices for protection 402 at the left branch of the voltage level shifter block 302. The gate terminal of the first MOS device N4 is connected to a n-type bias voltage (biasN). When the first MOS device N4 is connected to a biasN voltage, the first MOS device N4 may create a first low resistance path for the current to flow in the voltage level shifter block 302. The first MOS device N4 creates a low resistance path in between the current mirror block 306 and the current generation block 304. The generation of the first low resistance path reduces the sizes of the p-type transistor (P1, P2, and P9) and the n-type of transistors (N1, N2 and 402) in the left branch of the voltage level shifter block. Therefore, the voltage level shifter circuit as disclosed herein, occupies a lower area (as compared to comparative examples).

In one or more embodiments, the first MOS device N4 increases the limit of the p-type feedback node (FBP) voltage by the p-type transistor P1 of a voltage level shifter block 302 when the voltage level shifter 302 works on low voltages. Therefore, the performance of the voltage level shifter circuit 300 increases at lower voltages. The first MOS device N4 bypasses the high resistance path generated by the stacked devices 402 and increases strengths of the p-type transistor P1 at the left branch of the voltage level shifter block that covers wide range of input-output (I/O) voltages. The first MOS device N4 strengthens the current mirror block 306 for covering wide range of IO voltages, especially when the p-type transistor P1 is weaker due to receiving low values of supply voltage.

In one or more embodiments, a second MOS device N3 is connected to the stacked devices for protection 402 at the left branch of the voltage level shifter block. In one or more embodiments, the second MOS device N3 is a NMOS device. The gate terminal of the second MOS device N3 at the left branch of the voltage level shifter block 302 is connected to the final output (OUT) of the voltage level shifter circuit 300. The drain terminal of the second MOS device N3 is connected to the source terminal of the first MOS device N4.

In one or more embodiments, a final output (OUT) of the voltage level shifter circuit 300 is connected to the gate terminal of the second MOS device N3 to generate the second low resistance path. The second low resistance path reduces the area requirements of the voltage level shifter circuit 300 by eliminating the need of increasing the size of the transistors.

The gate terminal of the second MOS device N3 is connected to the final output and the reliability issues are handled by the stacked devices for protection 402 and 404. The reliability issues may be avoided by restricting the current through the current generation block 304 through the second MOS device N3. Connecting the gate terminal of the second MOS device N3 to the final output makes a path from the second MOS device N3 to n-type transistors N1 and N2 in the current generation block 304 less resistive, therefore reducing the size of the transistors in the current generation block 304. Therefore, the current generation block (034) is driven up to a maximum capacity by the second low resistance path. The second low resistance path enables the voltage level shifter circuit 300 to cover a wide range of core voltages for voltage level shifting. The second MOS device N3 generates a second low resistive path, that enables the circuit to cover wide range of core voltages. The second MOS device N3 adds strength to the current generation block 304 for covering a wide range of core voltages, especially when core voltages are too low, for e.g., close to the threshold voltage of the n-type of transistor (V_{THN}). For example, the core voltages range from 0.3V to 1.5V.

In one or more embodiments, the p-type transistor block 316 is connected to the -N-side final output-326 of the voltage level shifter block. 316, in an example, is realized by the series of connection of p-type MOS devices P10 and P9, see FIG. 4. The p-type of transistor block 316 receives input from the first feedback path FB1 from the stacked devices for protection 402 in the left branch of the voltage level shifter block 302.

In one or more embodiments, when the supply is low and the frequencies are higher, the second feedback path FB2 charges at a slower rate, due to the lower strength of current mirror block 306. Therefore, the NMOS device N6 does not have much strength to pull down the N-side final output 426. To provide strength to the NMOS device N6, a p-type of transistor block 316 is connected to the stacked devices for protection 402 and the first feedback path FB1 is generated. The first feedback path FB1 is connected from the drain terminal of the stacked devices for protection 402 of the left branch of the voltage level shifter block 302 to the p-type transistor block 316. The first feedback path FB1 detects a first feedback from the drain terminal of the stacked devices for protection 402. The first feedback FB1 is detected earlier than the second feedback FB2 by the connection of the first feedback path FB1 to the stacked devices for protection 402, that stabilizes the NMOS device N6 in the N-side final output 326 which improves the frequency of voltage level shifter circuit 300 at low voltage supplies. The p type of transistor block 316 reduces the dependency of FB2 on the N-side final output 326 by detecting the first feedback FB1 early, ultimately helping in achieving improved frequencies at lower supplies where FB2 charges at a slow rate, due to lesser strengths of current mirror block 306.

In one or more embodiments, an n-type transistor block 318/(N8) connected using N-side final output (OUTN) 326 of the voltage level shifter circuit 300. In an example, 318 is realized by n-type MOS device N8 (see FIG. 4). The n-type of transistor block 318 takes input from N-side final output (OUTN) of the voltage level shifter circuit 300. The n-type transistor block 318 pulls down the second feedback path (FB2) to logic low voltage level by taking input from the N-side final output (OUTN) of the voltage level shifter circuit 300.

In one or more embodiments, an n-type transistor block 318 is connected to an output side of the current mirror block 306. The n-type of transistor block 318 takes input from the N-side final output 326 of the voltage level shifter circuit. At high frequencies and low voltages, the second feedback path FB2 needs to pull the final output OUT 324 to Supply (logic high) level. As the discharging time of the second feedback path is more, therefore the n-type transistor block 318 is connected to the second feedback path (FB2) using the N-side final output (OUTN). The n-type transistor block 318 detects logic high of the final output OUT sooner. A signal from the right-side output block 326 is connected to a gate terminal of the n-type transistor block 318. The connection of the output OUTN to the gate terminal of the n-type transistor block 318 detects the logic high of the final output sooner by boosting a logic low of FB2 soon. The early detection of the second feedback enables the voltage level shifter circuit 300 to operate at low supplies and higher frequencies. The generated output is stable at high frequencies and low supply voltages.

The n-type transistor block 318 pulls down the second feedback (FB2) reach to a logic low voltage level. The p-type transistor P4 receives the second feedback (FB2) at logic low. The p-type transistor P4 drives the final output (OUT) to logic high, upon receiving the logic low second feedback (FB2). A body terminal of P4 (the outward arrow shown at the middle of the channel) is connected to DVDD. The final output (OUT) generated is stable at high frequencies and low supply voltages.

For example, the voltage level shifter circuit may achieve voltage operation of 0.85 to 2.07V on the input-output side and 0.38 to 1.1V on the core voltage side, wherein the core voltage coverage is limited by the threshold voltage (V_{TH}) core devices.

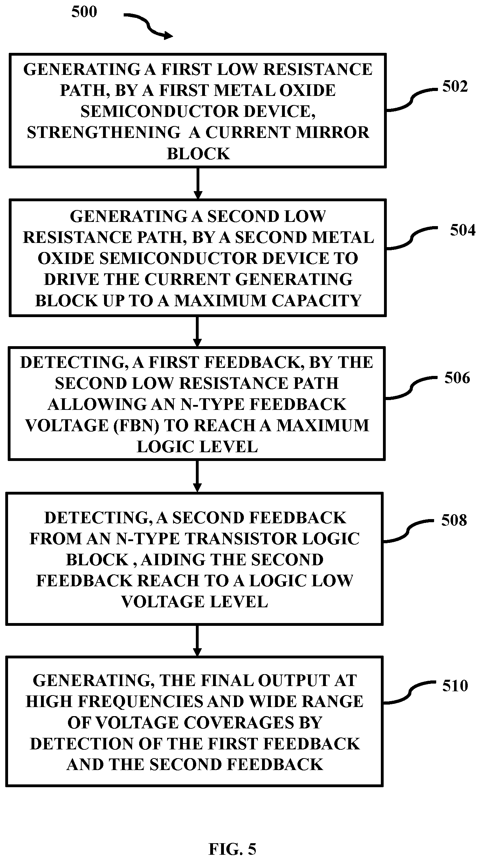

FIG. 5 shows a flowchart for a method to shift the level of voltage in a voltage level shifter circuit according to one or more embodiments. At operation 502, the first low resistance path is generated, by the first metal-oxide semiconductor (MOS) device in between the current generation block 304 and the current mirror block 306. The first MOS device 308 generates a low resistance path to bypass a high resistance path generated by the transistor block 314 at the left branch of the voltage level shifter block. At operation 504, the second low resistance path is generated by connecting the second MOS 312 to an n-type of transistor N3 at the left branch of the voltage level shifter block 302. A final output 326 of the voltage level shifter circuit to a gate terminal of a second MOS device 312 to drive, the current mirror block 306 up to a maximum capacity by second low resistance path of the second MOS device. Therefore, the voltage level shifter covers a wide range of core voltages. An operation 506, a first feedback generated from the stacked devices for protection 402 is connected to a p-type transistor block 316 at the right branch of the voltage level shifter block. The connection of the stacked devices for protection 402 to the p-type transistor block 316 creates the second low resistance path. The first feedback is detected early at the p-type transistor block 316, that improves the frequency of the voltage level shifter circuit at low voltage supplies. The first feedback path FB1 boosts the n-type feedback voltage to reach the maximum logic level in the voltage level shifter circuit in a given time period. The first feedback FB1 generated boosts FBN to reach maximum logic level which provides more overdrive to NMOS device N6. The gate threshold voltage to the NMOS N6 is improved by boosting the n-type feedback voltage to reach a maximum logic level. At operation 508, the second feedback is taken from the n-type transistor block 318. The n-type transistor block 318 pulls down the second feedback to logic zero by taking input from the N-side final output 426 of the voltage level shifter circuit, driving the p-type transistor P4 to generate a final output at logic high. At operation 510, a final output is generated after the second feedback is detected from the n-type transistor block. The output generated is stable at high frequencies and low supply voltages.

The various actions in method 500 may be performed in the order presented, in a different order or simultaneously. Further, in some embodiments, some actions listed in FIG. 5 may be omitted.

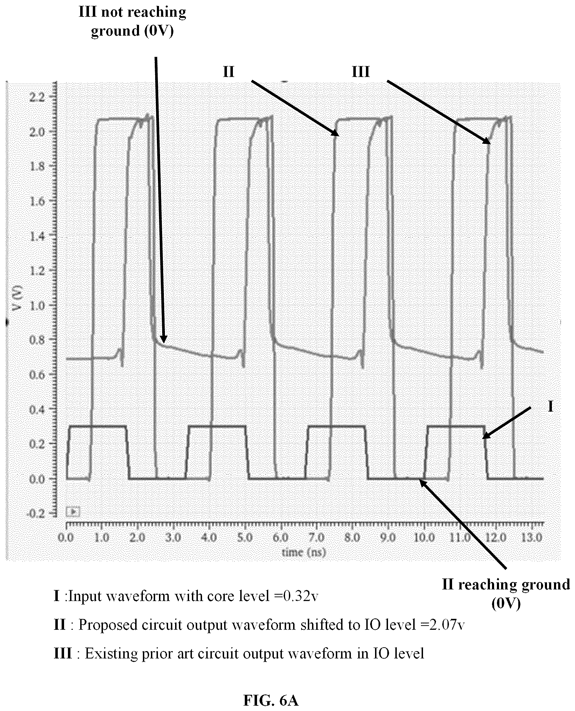

FIG. 6A shows a graphical representation of an example for level shifting from core level voltage to IO level voltage, according to one or more embodiments. In the example, the core voltage level is given as 0.32V as input and is represented as "I". A graph for comparing the output of the proposed circuit (II) with the output of the comparative example circuit (III) is plotted. The X axis shows time in nanosecond versus Y axis is the Voltage (in Volts). When the input core voltage I is given as 0.32V, the output of the proposed circuit (II) is 2.07V. And the output of the comparative example circuit III as 2.07 V is for a lesser amount of time as compared to the output of the proposed circuit (II). The comparative example circuit does not reach to the ground, i.e. 0V. The output of the proposed circuit reaches to 0V.

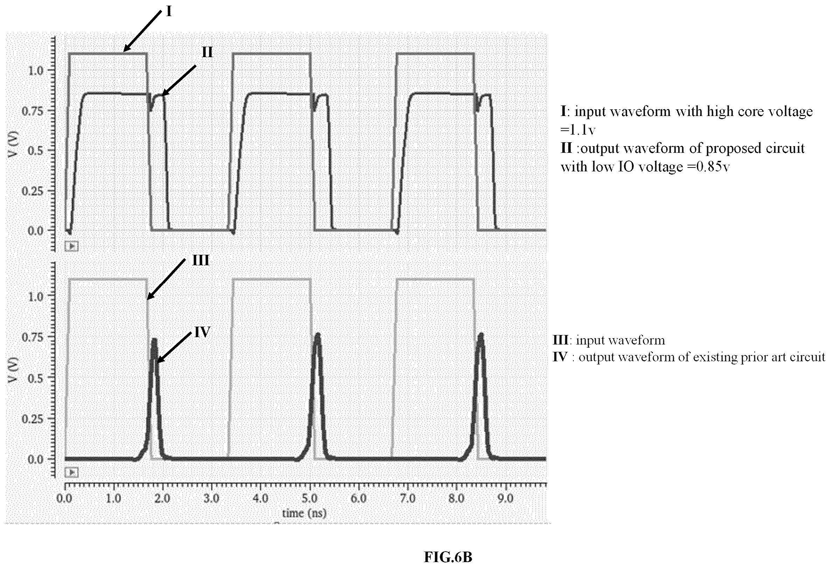

FIG. 6B shows a graphical representation of an example for level shifting from core level voltage to low IO level voltage, according to one or more embodiments. In the example, the core voltage level is given as 1.1 V as input and is represented as "I" and "III". A graph for comparing the output of the proposed circuit (II) with the output of the comparative example circuit (IV) is plotted. The X axis shows time in nanosecond versus Y axis is the Voltage (in Volts). When the input core voltage I is given as 1.1V, the output of the proposed circuit (II) is 0.85V, and the output pulse stays for 2.0 ns. When the input core voltage I is given as 1.1V, the output of the comparative example circuit IV as 0.85 V is for a lesser amount of time as compared to the output of the proposed circuit (II), that is the output peaks for only about 0.1 ns.

One or more embodiments described herein are directed to a voltage level shifter circuit. Therefore, it is understood that the scope of the disclosure extends to a program and in addition to a non-transitory computer readable medium having instructions therein, such computer readable storage medium contain program code or instructions for implementation of one or more operations of the method, when the program runs on a server or mobile device or any suitable programmable device. The method is implemented in at least one embodiment through or together with a software program written in e.g., Very high speed integrated circuit Hardware Description Language (VHDL) another programming language, or implemented by one or more VHDL or several software modules being executed on at least one hardware device. The hardware device can be any kind of portable device that can be programmed. The device may also include hardware such as, e.g., an application-specific integrated circuit (ASIC), or a combination of hardware and software, e.g., an ASIC and a field-programmable gate array (FPGA), or at least one microprocessor and at least one memory with software modules located therein. The method embodiments described herein may be implemented partly in hardware and partly in software.

While certain example embodiments have been particularly shown and described, it will be understood that various changes in form and details may be made therein without departing from the scope of the following claims.

## Claims

1. A level shifter circuit comprising:
a p-type transistor;
a first metal-oxide semiconductor (MOS) device (308) connected to the p-type transistor;
a voltage level shifter block comprising:
a current mirror block, wherein the first MOS device is connected to the current mirror block at a left branch of the voltage level shifter block,
a current generation block,
a transistor block, and a second MOS device (312) connected to the transistor block (314) and to the current generation block (304)of the left branch (320), wherein a gate terminal of the second MOS device (312) is connected to a final output (324) of the level shifter circuit (300), and a source terminal of the first MOS device (308) is connected to a drain terminal of the second MOS device (312);
a p-type transistor logic block (316)connected to an N-side final output (326) of the voltage level shifter block (302), wherein the p-type transistor block (316) is configured to receive an input from the left branch; and
an n-type transistor block (318) connected at a right branch (322) of the level shifter circuit (300), wherein the n-type transistor block is configured to receive an input from the N-side final output (326) of the level shifter circuit (300).

2. The level shifter circuit as claimed in claim 1, wherein the level shifter circuit (300) is configured to tolerate a high voltage over a frequency range, and the level shifter circuit is a single stage level shifter circuit.

3. The level shifter circuit as claimed in any preceding claim, wherein the first MOS device (308) is configured to generate a first resistance path to bypass a third resistance path generated by the p-type transistor (310) and the transistor block (314) at the left branch of the voltage level shifter block (302).

4. The level shifter circuit as claimed in claim 3, wherein the first resistance path provided by the first MOS device (308) strengthens the current mirror block (306).

5. The level shifter circuit as claimed in claim 4, wherein a connection of the final output (324) of the level shifter circuit (300) to the gate terminal of the second MOS device is configured to generate a second resistance path, thereby reducing a resistance created by the transistor block (314)ofthe left branch (320) of the voltage level shifter block (302).

6. The level shifter circuit as claimed in claim 5, wherein the second low resistance path by the second MOS device (312) is configured to strengthen the transistor block (314) that is configured to support a frequency range of core voltages.

7. The level shifter circuit as claimed in claim 5 or claim 6, wherein the current mirror block (306) is assisted in reaching to a capacity of voltage by the second resistance path.

8. The level shifter circuit as claimed in any preceding claim, wherein the p-type transistor block (316) is connected to the N-side final output (326), and
wherein the p-type transistor block (316) is configured to pull up an n-side of the N-side final output (326) to a supply voltage.

9. The level shifter circuit as claimed in any preceding claim, wherein a first feedback path (FB1) is connected from the transistor block (314) to the p-type transistor block (316) of the right branch (322) of the voltage level shifter block (300),
the first feedback path (FB1) is configured to provide a first feedback from a second resistance path connected to the transistor block (314), and
the first feedback is configured to boost an n-type feedback voltage to a maximum logic level in the level shifter circuit (300) for handling high frequencies at low voltages.

10. The level shifter circuit as claimed in any preceding claim, wherein the n-type transistor block (318) is configured to pull down a second feedback path(FB2) to a logic low voltage level.

11. A method to shift a level of a voltage in a level shifter circuit, the method comprising:
generating a first low resistance path, by a first metal oxide semiconductor (MOS) device (308), through the first MOS device (308) from a p-type transistor (310) connected to a current generation block (304) and to a current mirror block (306), thereby strengthening the current mirror block, wherein (306) a voltage level shifter block comprises the current mirror block (302);
generating a second low resistance path via a connection of a final output of the level shifter circuit to a gate terminal of a second MOS device (312) to drive, the current mirror block (306) up to a maximum capacity;
receiving a first feedback, provided by the second low resistance path connected to a p-type transistor block (316), wherein the first feedback is configured to boost an n-type feedback voltage (FBN) to reach a maximum logic level;
receiving a second feedback (FB2) from an n-type transistor block (318); and
generating the final output at high frequencies and over a range of voltages based on the first feedback and the second feedback.

12. The method as claimed in claim 11, wherein the method comprises generating the final output,
wherein the final output comprises a high frequency output.

13. The method as claimed in claim 11 or claim 12, wherein the method comprises shifting of a range of core voltage levels to a range of I/O voltage levels.

14. The method as claimed in any of claims 11 to 13, wherein the method comprises operating the level shifter circuit (300) as a single stage level shifter circuit.

15. The method as claimed in any of claims 11 to 14, wherein the method comprises bypassing, by the first low resistance path generated by the first MOS device (308), a high resistance path generated by the p-type transistor (310) at a left branch (320) of the voltage level shifter block (302), strengthening the current mirror block (306) of the voltage level shifter block (302) that covers a range of input-output (I/O) voltages.

## Amended claims

### Amended claims in accordance with Rule 137(2) EPC.

1. A level shifter circuit comprising:
a p-type transistor;
a first metal-oxide semiconductor (MOS) device (308) connected to the p-type transistor;
a voltage level shifter block comprising:
a current mirror block, wherein the first MOS device is connected to the current mirror block at a left branch of the voltage level shifter block,
a current generation block,
a transistor block, and a second MOS device (312) connected to the transistor block (314) and to the current generation block (304) of the left branch (320), wherein a gate terminal of the second MOS device (312) is connected to a final output (324) of the level shifter circuit (300), and a source terminal of the first MOS device (308) is connected to a drain terminal of the second MOS device (312),
wherein the left branch comprises the p-type transistor, the first MOS device, the transistor block, and the second MOS device,
a p-type transistor logic block (316) connected to an N-side final output (326) of the voltage level shifter block (302), wherein the p-type transistor block (316) is configured to receive an input from the left branch; and
an n-type transistor block (318) connected at a right branch (322) of the level shifter circuit (300), wherein the n-type transistor block is configured to receive an input from the N-side final output (326) of the level shifter circuit (300),
wherein the right branch comprises the p-type transistor block and the n-type transistor block,
wherein the first MOS device (308) is configured to generate a first resistance path to bypass a third resistance path generated by the p-type transistor (310) and the transistor block (314) at the left branch of the voltage level shifter block (302).

2. The level shifter circuit as claimed in claim 1, wherein the level shifter circuit (300) is configured to tolerate core voltages in a range from 0.3V to 1.5V, IO voltages in a range from 0.8V to 2.2V, and frequencies up to 300MHz, and the level shifter circuit is a single stage level shifter circuit.

3. The level shifter circuit as claimed in any preceding claim, wherein the first resistance path provided by the first MOS device (308) strengthens the current mirror block (306) for covering a wider range of IO voltages.

4. The level shifter circuit as claimed in claim 3, wherein a connection of the final output (324) of the level shifter circuit (300) to the gate terminal of the second MOS device is configured to generate a second resistance path, thereby reducing a resistance created by the transistor block (314) of the left branch (320) of the voltage level shifter block (302).

5. The level shifter circuit as claimed in claim 4, wherein the second low resistance path by the second MOS device (312) strengthens the current generation block (304) for covering a wider range of core voltages, wherein the current generation block (304) is configured to support frequency up to 300MHz and core voltages in a range from 0.3V to 1.5V.

6. The level shifter circuit as claimed in claim 4 or claim 5, wherein the current mirror block (306) is assisted in reaching a maximum capacity by the second resistance path.

7. The level shifter circuit as claimed in any preceding claim, wherein the p-type transistor block (316) is connected to the N-side final output (326), and
wherein the p-type transistor block (316) is configured to pull up a node of the N-side final output (326) to a supply voltage.

8. The level shifter circuit as claimed in any preceding claim, wherein a first feedback path (FB1) is connected from the transistor block (314) to the p-type transistor block (316) of the right branch (322) of the voltage level shifter block (300),
the first feedback path (FB1) is configured to provide a first feedback from a second resistance path connected to the transistor block (314), and
the first feedback is configured to boost a feedback voltage to a maximum logic level in the level shifter circuit (300).

9. The level shifter circuit as claimed in any preceding claim, wherein the n-type transistor block (318) is configured to pull down a second feedback path (FB2) to a logic low voltage level.

10. A method to shift a level of a voltage in a level shifter circuit, the method comprising:
generating a first low resistance path, by a first metal oxide semiconductor (MOS) device (308), through the first MOS device (308) from a p-type transistor (310) connected to a current generation block (304) and to a current mirror block (306), thereby bypassing a high resistance path generated by a transistor block (314) and strengthening the current mirror block for covering a wider range of IO voltages, wherein a voltage level shifter block (302) comprises the current mirror block (306);
generating a second low resistance path via a connection of a final output of the level shifter circuit to a gate terminal of a second MOS device (312) to drive the current mirror block (306) up to a maximum capacity;
receiving a first feedback, provided by the second low resistance path connected to a p-type transistor block (316), wherein the first feedback is configured to boost an n-type feedback voltage (FBN) to reach a maximum logic level;
receiving a second feedback (FB2) from an n-type transistor block (318); and generating the final output based on the first feedback and the second feedback.

11. The method as claimed in claim 10, wherein the method comprises generating the final output,
wherein the final output comprises an output having a frequency up to 300MHz.

12. The method as claimed in claim 10 or claim 11, wherein the method comprises shifting of a range of core voltage levels to a range of I/O voltage levels.

13. The method as claimed in any of claims 10 to 12, wherein the method comprises operating the level shifter circuit (300) as a single stage level shifter circuit.

14. The method as claimed in any of claims 10 to 13, wherein the method comprises bypassing, by the first low resistance path generated by the first MOS device (308), a high resistance path generated by the p-type transistor (310) at a left branch (320) of the voltage level shifter block (302) wherein the left branch comprises the p-type transistor, the first MOS device, and the second MOS device, strengthening the current mirror block (306) of the voltage level shifter block (302) for covering a wider range of IO voltages, wherein the current mirror block (306) covers a range of input-output (I/O) voltages.
